# EUROPEAN PATENT APPLICATION

(11) **EP 4 818 707 A1**
(43) Date of publication of application: **07.10.2026**
(21) Application number: 25167498.2
(22) Date of filing: 31.03.2025
(51) Int. Cl.: G01R 15/16

(54) **VOLTAGE MEASUREMENT SENSOR**

(71) Applicant: LEM International SA, 1217 Meyrin (CH)
(72) Inventor: BUHLMANN, Félix, 1010 LAUSANNE (CH)
(74) Representative: reuteler & cie SA

(57) **Abstract**

A voltage measurement sensor (1) comprising:
- a conducting wire (12);
- a dielectric body (6) surrounding the conducting wire;
- an outer screen (5) surrounding the dielectric body (6); and
- a capacitive voltage sensing arrangement (3) configured to measure a voltage on the conducting wire (12), comprising an electrode (7) and an outer conductor (9) mounted in contact with the outer screen. A first capacitance (C1) is formed by the conducting wire, the dielectric body, and the electrode, and a second capacitance (C2) is formed by the electrode and the outer conductor, the first capacitance (C1) being electrically connected in series to the second capacitance (C2). The outer conductor comprises a reference voltage terminal configured to provide a connection to an alternating reference voltage source such that the outer conductor is electrically driven by the reference voltage source.

## Description

### Technical field

The present invention relates to a voltage measurement sensor for measuring a voltage on a conductor wire having an outer screen, in particular for medium voltage systems.

### Background

A capacitive voltage divider is commonly used to measure voltages in medium- and high-voltage systems, typically ranging from 1 kV to 36 kV and above. It offers several advantages over resistive dividers. Unlike resistive voltage dividers, which continuously consume power and dissipate energy as heat, capacitive dividers are highly efficient and minimize power loss. Additionally, they do not generate thermal noise, making them suitable for low-noise applications. Capacitive voltage dividers are particularly effective for AC signals and highfrequency applications. They also have a high voltage withstand capability, making them well-suited for medium and high-voltage measurements.

However, capacitive voltage dividers have some limitations. Since the voltage division is determined by capacitive reactance, it depends on the system voltage frequency. Any change in frequency alters the reactance, leading to variations in the voltage ratio. Additionally, the capacitance values are often not precisely defined and can fluctuate over time due to environmental factors such as temperature, humidity, and aging. As a result, the measurement accuracy of capacitive voltage dividers is lower compared to resistive dividers, making them less suitable for applications requiring high precision.

### Summary

In view of the foregoing, it is an object of the invention to provide a voltage measurement sensor for a conductor wire with an outer screen, which is accurate.

It is advantageous to provide a voltage measurement sensor for medium voltage systems which is economical to produce.

It is advantageous to provide a voltage measurement sensor for medium voltage systems which is easy to install and couple to.

Objects of the invention have been achieved by providing a voltage measurement sensor according to claim 1.

Dependent claims set out various advantageous features of embodiments of the invention.

Disclosed herein is a voltage measurement sensor comprising:
- a conducting wire;
- a dielectric body surrounding the conducting wire;
- an outer screen surrounding the dielectric body; and
- a capacitive voltage sensing arrangement configured to measure a voltage on the conducting wire.

The capacitive voltage sensing arrangement comprises an electrode and an outer conductor mounted in contact with the outer screen. A first capacitance (C1) is formed between the conducting wire and the electrode, and a second capacitance (C2) is formed between the electrode and the outer conductor, the first capacitance (C1) being electrically connected in series to the second capacitance (C2).

The outer conductor comprises a reference voltage terminal configured to provide a connection to an alternating reference voltage source such that the outer conductor is electrically driven by the reference voltage source.

In an advantageous embodiment, the outer screen comprises or consists of a semiconductive material.

In an advantageous embodiment, the electrode comprises a first electrode portion and a second electrode portion, the first electrode portion and the second electrode portion being electrically coupled, wherein the first capacitance is formed by the conductive wire, a dielectric portion, and the first electrode portion and the second capacitance is formed by the second electrode portion, a dielectric portion, and the outer screen.

In an advantageous embodiment, the second electrode portion has a length extending parallel to a section of the conducting wire, and the first electrode portion has a height extending transversely to said section of the conducting wire and projecting through an orifice in the outer screen.

In an advantageous embodiment, the outer conductor comprises a screen portion that concentrically surrounds the conducting wire, and a connection portion upstanding from the screen portion.

In an advantageous embodiment, the screen portion of the outer conductor completely surrounds by 360° the conducting wire.

In an advantageous embodiment, the connection portion upstanding from the screen portion concentrically surrounds the second electrode portion of the electrode.

In an advantageous embodiment, the connection portion of the outer conductor completely surrounds by 360° the second electrode portion.

In an advantageous embodiment, the outer conductor and the first electrode portion comprise a coaxial coupling interface for a coaxial coupling to a complementary connector connected to a signal processing circuit.

In an advantageous embodiment, the sensor further comprises an inner screen surrounding the conducting wire, wherein the inner screen is positioned between the conducting wire and the dielectric body.

In an advantageous embodiment, the inner screen comprises or consists of a semiconductive material.

In an advantageous embodiment, the capacitive voltage sensing arrangement further comprises a signal processing circuit which comprises the reference voltage source, and an output voltage measurement signal processing circuit.

In an advantageous embodiment, the reference voltage source is configured to supply the reference voltage ***V_{ref}*** at a reference frequency ***f_{ref}*** greater than a line frequency of the voltage in the conducting wire, preferably at least 50% greater.

In an advantageous embodiment, the peak value of the reference voltage is preferably at least 100 times smaller, for instance up to or more than 1000 times smaller, than the nominal line voltage in the conducting wire 12. The reference voltage may be as small as about 1V and for instance in a range of 1V to 100V, preferably in a range of 1V to 50V.

In an advantageous embodiment, the outer screen comprises an opening configured to provide an access to the first output terminal, the electrode and the dielectric body having respective portions extending through the opening of the outer screen.

In an advantageous embodiment, the outer conductor is mounted on top of the outer screen and around the opening of the outer screen.

Further advantageous features of the invention will be apparent from the following detailed description of embodiments of the invention and the accompanying illustrations.

### Brief description of the figures

Figure 1a is a circuit diagram of a voltage measurement sensor according to an embodiment of the invention;
Figure 1b is a cross-sectional schematic diagram of a voltage measurement sensor according to the embodiment illustrated in Figure 1a;
Figure 2a is a cross-sectional schematic diagram of a voltage measurement sensor according to an embodiment of the invention;
Figure 2b is an enlarged cross-sectional schematic diagram of a voltage measurement sensor according to an embodiment of the invention;

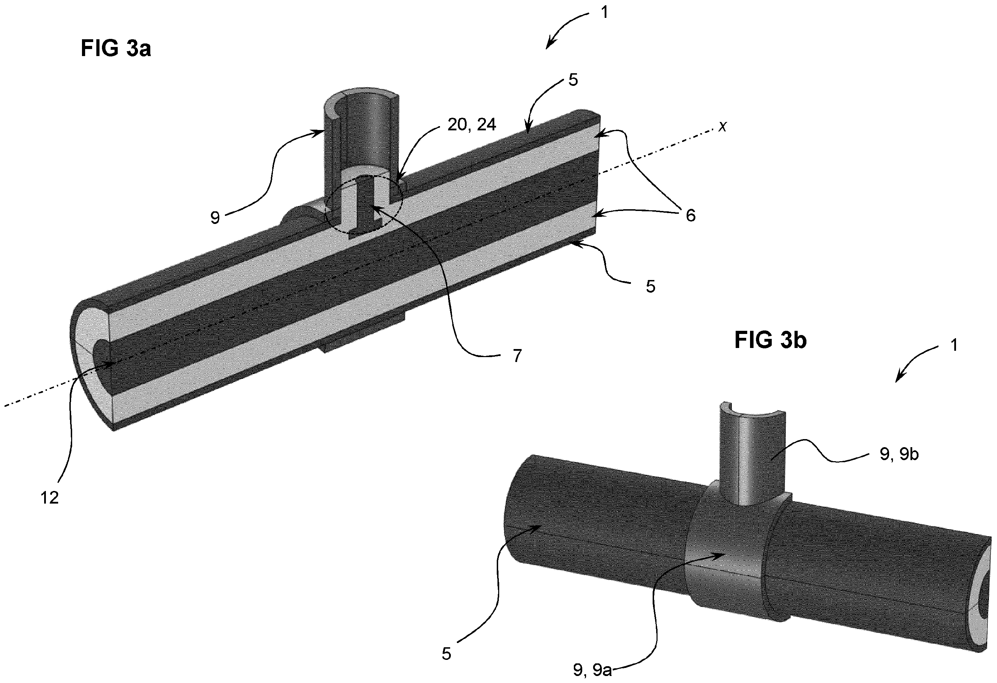

Figure 3a is a cross-sectional perspective view of a voltage measurement sensor according to an embodiment of the invention;
Figure 3b is another perspective view of the voltage measurement according to the embodiment illustrated in Figure 3a;
Figure 4 is a graph of a frequency-domain representation of a measured output voltage at an output terminal of the voltage measurement sensor according to an embodiment of the invention.

### Descriptions

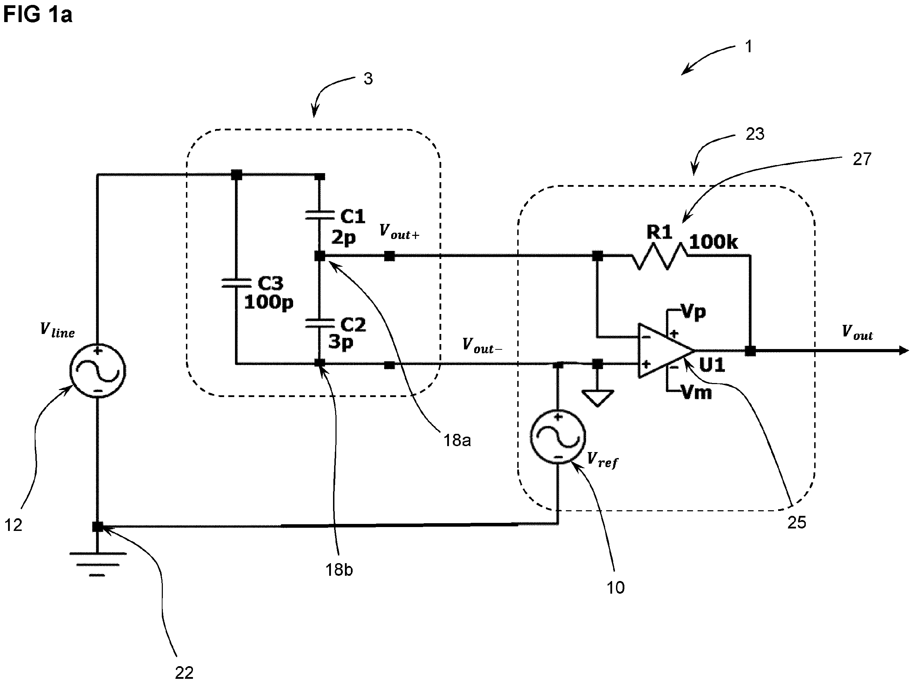

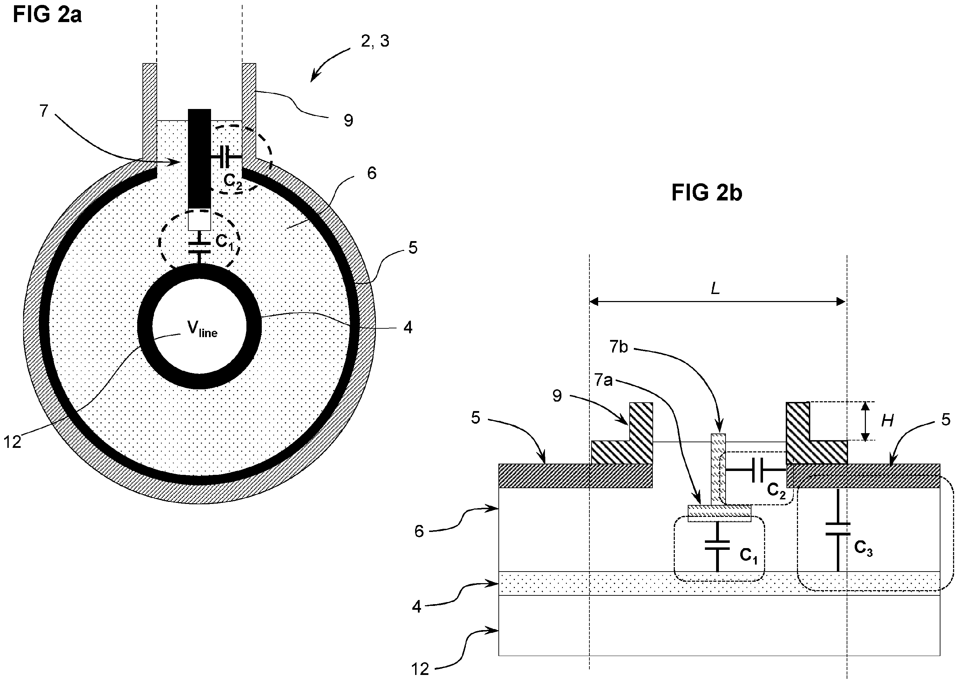

Referring to the figures, starting with Figures 1a to 2b, a voltage measurement sensor 1 according to embodiments of the invention comprises a coaxial arrangement including a conductive wire 12, a dielectric body 6 which surrounds the conductive wire 12, and an outer screen 5 disposed around the dielectric body 6.

The voltage measurement sensor 1 may optionally further comprise an inner screen 4 surrounding the conducting wire 12. The inner screen 4 is positioned between the conducting wire 12 and the dielectric body 6.

The voltage measurement sensor 1 comprises a capacitive voltage sensing arrangement 3 configured to measure a line voltage ***Vₗᵢₙₑ*** on the conducting wire 12.

The capacitive voltage sensing arrangement 3 comprises an electrode 7 and an outer conductor 9 mounted around the electrode 7. The electrode 7 may comprise a first electrode portion 7a and a second electrode portion 7b. A first capacitance C1 is formed by the conducting wire 12, a portion of the dielectric body 6, and the electrode 7, more particularly the first electrode portion 7b. A second capacitance C2 is formed by the electrode 7, more particularly the second electrode portion 7b, a portion of the dielectric body 6, and the outer conductor 9.

The first electrode portion 7a and the second electrode portion 7b are directly connected, for instance formed of a single integral conductive material, such that the first capacitance C1 and the second capacitance C2 are electrically coupled in series.

The outer conductor 9 is mounted against and in contact with the outer screen 5 and around a portion of the dielectric body. The outer conductor 9 comprises a reference voltage terminal 18b which is configured to provide an electrical connection to a reference voltage source 10. When the reference voltage source 10 provides a reference voltage ***V_{ref}*** to the outer conductor 9, the outer conductor 9 is electrically driven by the reference voltage source 10. A portion of a surface of the outer screen 5, against which the outer conductor 9 is mounted and in contact, is referred to as a reference voltage interface of the outer screen 5. The outer conductor 9 provides electrical connection between the reference voltage source 10 and a ground 22.

The outer conductor 9 comprises a low resistance conductive material, preferably a metal conductor such as copper, aluminum, or corrugated copper or aluminum screen, tape, or sheath which may be a separately formed part assembled to the outer sheath and dielectric body, or deposited by an additive process on the outer sheath and dielectric body. The outer conductor 9 is mounted such that the outer conductor 9 extends at least partially around the outer screen, and around the dielectric portion surrounding the second electrode portion. In such cases, the second capacitance C2 is further formed by the outer conductor 9 depending on dimension of the electrode 7 or the second electrode portion 7b.

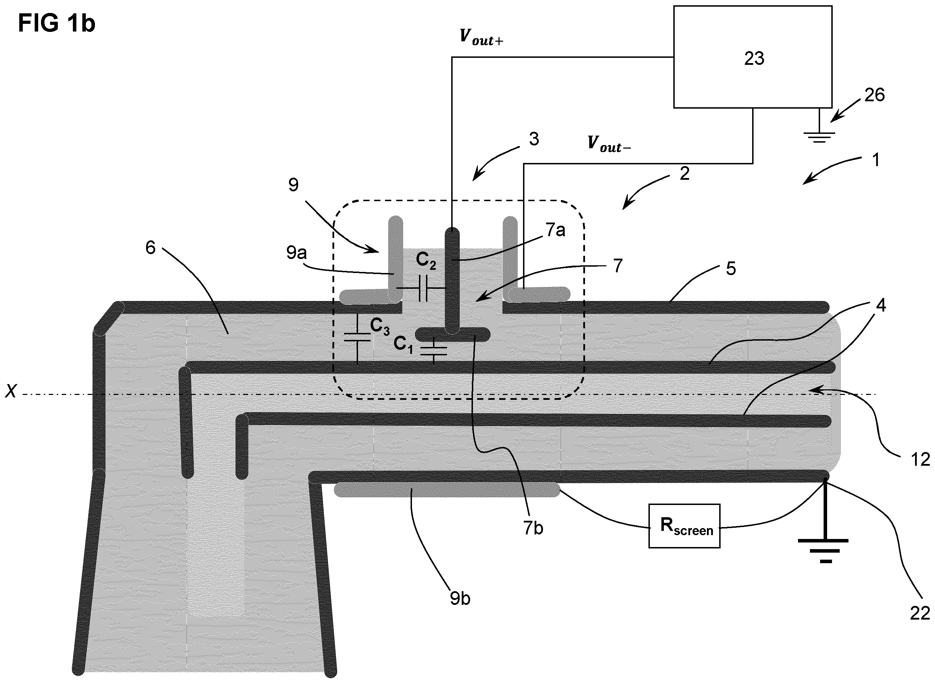

When the conducting wire 12 carries a line voltage ***Vₗᵢₙₑ*** and the outer screen 5 is electrically driven by the reference voltage ***V_{ref}*** of the reference voltage source 10, the two different voltage sources are electrically connected to the voltage sensing arrangement 3, i.e. the line voltage ***Vₗᵢₙₑ*** to the first capacitance C1 and the reference voltage ***V_{ref}*** to the second capacitance C2, respectively, as input voltage sources to the capacitive voltage sensing arrangement 3 as shown in Figures 1a, 1b.

In an embodiment, the capacitive voltage sensing arrangement 3 may further comprise a signal processing circuit 23 comprising an operational amplifier 25 and a resistor 27 as shown in Figure 1a. For instance, a printed circuit board (PCB) disposed close to the electrode 7 comprises the signal processing circuit 23. Alternatively, the signal processing circuit 23 may be comprised in an external signal processing unit.

**The** capacitive voltage sensing arrangement 3 further comprises a first output terminal 18a for connection to a first output voltage ***V*_{*out*+}** and a second output terminal 18b for connection to a second output voltage ***V*_{*out*-}**. **The** first output terminal 18a is comprised in the electrode **7. The** outer conductor 9 comprises the reference voltage terminal forming the second output terminal 18b.

**The** first output terminal 18a is connected a first input of the operational amplifier 25, preferably the inverting input of the operational amplifier 25. **The** second output terminal 18b is connected to a reference voltage point 26 (Figure 1a) and to the second input of the operational amplifier 25.

**The** operational amplifier 25 accepts the output from the first output terminal 18a and outputs an output voltage ***Vₒᵤₜ**.* A gain of the operational amplifier 25 is established by a resistor 27 with resistance value R1 (Figure 1a). **The** output voltage ***Vₒᵤₜ*** measured at the output of the operational amplifier 25 comprises a spectral line output component ***V_{line_out}*** of the line voltage ***Vₗᵢₙₑ*** at the line frequency ***fₗᵢₙₑ*** and a spectral reference output component ***V_{ref_out}*** at a reference frequency ***f_{ref}**.*

Considering the conducting wire 12 carries the line voltage ***Vₗᵢₙₑ*** at a line frequency ***fₗᵢₙₑ*** and the reference voltage source supplies the reference voltage ***V_{ref}*** at a reference frequency ***f_{ref}***, using the capacitive voltage sensing arrangement 7, the line voltage ***Vₗᵢₙₑ*** can be calculated as follows: ${V}_{line} = \frac{{f}_{ref}}{{f}_{line}} ⋅ \frac{{V}_{line _ out}}{{V}_{ref _ out}} {V}_{ref}$ , where ***V_{ref}***, ***f_{ref}***, and ***fₗᵢₙₑ*** are known values and ***V_{line_out}*** and ***V_{ref_out}*** are measured at the output terminal of the operational amplifier 25.

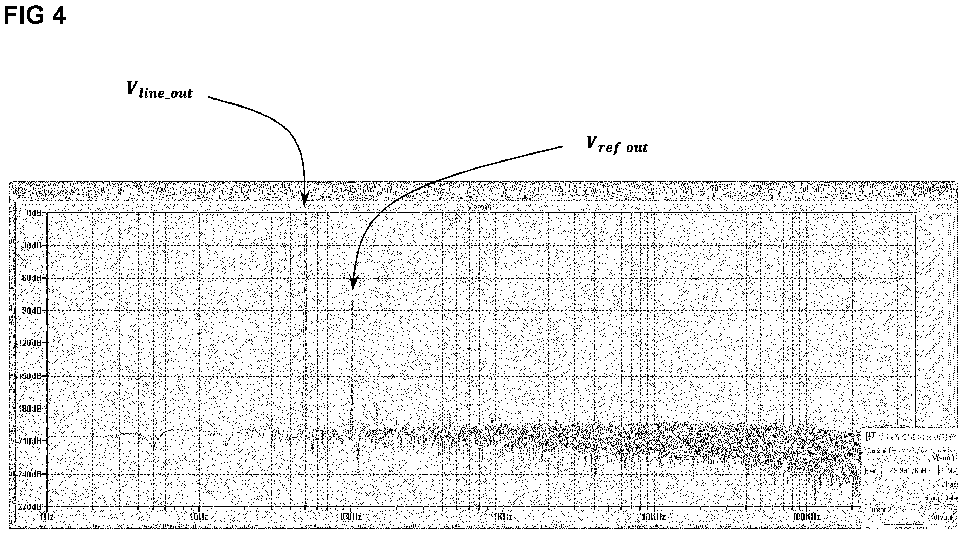

The reference voltage source 10 can be an oscillator generating sinusoidal waveforms with frequencies preferably above 100 Hz, allowing the voltage waveform provided by the reference voltage source 10 to be easily distinguished from the voltage waveform on the conducting wire 12 (such as 50 Hz or 60 Hz power systems and their possible harmonics). Figure 4 shows the output voltage ***Vₒᵤₜ*** of the operational amplifier 25 when the reference voltage ***V_{ref}*** at the reference frequency ***f_{ref}*** of 101 Hz and the line voltage ***Vₗᵢₙₑ*** at the line frequency ***fₗᵢₙₑ*** of 50 Hz are supplied to the capacitive sensing arrangement 3 (the output voltage is represented in frequency-domain). The line output component ***V_{line_out}*** and the reference output component ***V_{ref_out}*** are separated by their frequency difference. As described above, due to the frequency difference between the line voltage carried by the conducting wire 12 and the reference voltage supplied by the reference voltage source 10, each voltage component is easily differentiated.

The nominal voltage of conducting wires in applications of the present invention may typically be greater than 1kV and for instance in a range of 3kV to 70kV, more often in a range of 3kV to 36kV. The peak value of the reference voltage generated by the reference voltage source 10 is preferably at least 100 times smaller, for instance up to 1000 times smaller, or exceeding 1000 times smaller, than the nominal line voltage in the conducting wire 12. The reference voltage may be as small as about 1V and for instance in a range of 1V to 100V, preferably in a range of 1V to 50V. Low reference voltages are easier to drive by the reference voltage source and may also be advantageous for safety reasons, than higher reference voltages.

The capacitive sensing arrangement 3 further has a third capacitance C3 formed by the conducting wire 12 and the outer screen 5 separated by the dielectric body 6. The third capacitance C3 is coupled to the first and the second capacitances C1, C2 in parallel. The third capacitance C3 bypasses capacitive current, but it does not influence the measurement of the line voltage.

It is known that a conventional capacitive voltage divider comprises a first and a second capacitance connected in series between a high-voltage source and ground. A voltage output measurement is taken from a junction between these two capacitances to measure the voltage drop across the second capacitance connected to ground, and the voltage output is inversely proportional to the ratio of the second capacitance's capacitance to the total capacitance of both capacitances. Its accuracy however depends on the capacitance values as well as their impedance, which varies with the frequency of the high-voltage source. At low frequencies, the capacitive reactance increases, resulting in a higher impedance, which can reduce the current flow through the divider and slow its response. At higher frequencies, the impedance of the capacitances decreases, affecting the voltage division ratio and potentially introducing errors if not properly accounted for. Additionally, temperature variations can significantly affect the accuracy of the voltage measurement, as capacitance values are influenced by the dielectric properties of the insulating materials.

The invention overcomes the aforementioned problems by providing the alternating reference voltage to the second capacitance C2 instead of grounding the second capacitance C2. As shown in the equation above, the calculation of the line voltage of the conducting wire 12 is not affected by multiple factors that influence capacitance, which is subject to change and often poorly defined. Therefore, the voltage measurement sensor 1 can improve the measurement accuracy of the line voltage of the conductor wire 12.

The outer screen 5 comprises or consists of a semiconductive material as *per se* known in the art. For instance, the semiconductive material comprises a base material, such as crosslinked polyethylene, and a conductive filler, such as to achieve controlled electrical conductivity, generally ranging from 10² to 10⁶ Ω·m. The resistance of the outer screen 5 labeled as **R_{screen}.** The semiconductive material may further comprise additives, such as antioxidants, processing aids, stabilizers, and/or dispersing agents. The conductive filler can vary, with options such as acetylene black, known for its ultra-low sulfur content (<0.05%), or high-structure furnace black (HSF), which has a slightly higher sulfur concentration (0.05-0.1%). The formulation of the semiconductive material can be adjusted to optimize electrical performance, mechanical properties, and compatibility with the surrounding insulation and metallic shielding. The semiconductive material is advantageous if the dielectric body 6 comprises any voids or a small air gap. It helps control the electric field distribution, reducing sharp field enhancements that can trigger partial discharges.

In an embodiment, the inner screen 4 comprises or consists of a semiconductive material similar to the outer screen 5 as described above.

The outer screen 5 comprises an opening 20 through which allows to access the electrode 7 comprising the output terminal 18a of the capacitive voltage sensing arrangement 3.

The outer conductor 9 is mounted around the opening 20 by surrounding the outer screen 5 and comprises a tubular screen portion 9a. The screen portion 9a is mounted around the outer screen 5 and comprises an orifice 24. The orifice 24 is at least partially overlapped with the opening 20 of the outer screen 5, which allows to access to the first output terminal 18a of the capacitive voltage sensing arrangement 3. The electrode 7 and a portion of the dielectric body 6 extend through the opening 20 and the outer conductor 9 further comprises a connection portion 9b surrounding the extended portion of the dielectric body 6 and the electrode 7. The connection portion 9b is directly connected to the screen portion 9a of the outer conductor 9 around the orifice 24. Alternatively, even if the electrode 7 and/or the dielectric body 6 are not extended through the opening 20, the outer conductor 9 may comprises the connection portion 9b as described above. The length of the connection portion (i.e. height H in Figure 2b) can vary depending on the size of the opening 20 such that an electric field around the electrode 7 (an electric field from the capacitive voltage sensing arrangement 3) is not affected by influences of other electric fields.

A width L of the screen portion 9a the outer conductor 9 along an axis X of the conductive wire having a direct contact with the outer screen may be of various lengths, preferably slightly larger than a diameter of the connection portion 9b. Computer aided simulations have shown that increasing the length L from around the value of the diameter of the connection portion to around three times said diameter had a negligeable impact on the value of the first and second capacitance values C1, C2.

The voltage measurement sensor 1 may further comprise a coaxial coupling interface 2 connected to the electrode 7 and the outer conductor 9, and presenting the first output terminal 18a and the second output terminal 18b for connection to an external coaxial connector of the signal processing unit 23.

### List of references

Voltage measurement sensor 1
Coaxial coupling interface 2
Inner screen 4
Conducting wire 12
Dielectric body 6
Outer screen 5
   Reference voltage interface 14
   Opening 20
**Capacitive voltage sensing arrangement 3**
   Electrode 7
      First electrode portion 7a
      Second electrode portion 7b
   First capacitance C1
   Second capacitance C2
   Third capacitance C3
   Output end terminals 18
      First output terminal 18a
      Second output terminal 18b (Reference voltage terminal)
   Outer conductor 9
      Screen portion 9a
         Orifice 24
      Connection portion 9b
   Reference ground terminal 26
Ground terminal 22
Reference voltage source 10
Signal processing circuit 23
   operational amplifier 25
   resistor 27

## Claims

1. A voltage measurement sensor (1) comprising:
- a conducting wire (12);
- a dielectric body (6) surrounding the conducting wire;
- an outer screen (5) surrounding the dielectric body (6); and
- a capacitive voltage sensing arrangement (3) configured to measure a voltage on the conducting wire (12), comprising an electrode (7) and an outer conductor (9) mounted in contact with the outer screen, wherein a first capacitance (C1) is formed between the conducting wire and the electrode, and a second capacitance (C2) is formed between the electrode and the outer conductor, the first capacitance (C1) being electrically coupled in series to the second capacitance (C2),
- and wherein the outer conductor comprises a reference voltage terminal configured to provide a connection to an alternating reference voltage source such that the outer conductor is electrically driven by the reference voltage source.

2. The sensor of claim 1, wherein the outer screen (5) comprises or consists of a semiconductive material.

3. The sensor of any preceding claim, wherein the electrode comprises a first electrode portion (7a) and a second electrode portion (7b), the first electrode portion and the second electrode portion being electrically coupled, wherein the first capacitance is formed by the conductive wire, a dielectric portion, and the first electrode portion and the second capacitance is formed by the second electrode portion, a dielectric portion, and the outer screen.

4. The sensor of the preceding claim wherein the second electrode portion has a length extending parallel to a section of the conducting wire, and the first electrode portion has a height extending transversely to said section of the conducting wire and projecting through an orifice in the outer screen.

5. The sensor of the preceding claim, wherein the outer conductor comprises a screen portion (9b) that concentrically surrounds the conducting wire and a connection portion (9a) upstanding from the screen portion.

6. The sensor of the preceding claim wherein the screen portion of the outer conductor completely surrounds by 360° the conducting wire and dielectric body.

7. The sensor of either of the two directly preceding claims wherein the connection portion upstanding from the screen portion concentrically surrounds the second electrode portion (7b) of the electrode.

8. The sensor of the preceding claim wherein the connection portion of the outer conductor completely surrounds by 360° the second electrode portion.

9. The sensor of any preceding claim wherein the outer conductor and the first electrode portion comprise a coaxial coupling interface for a coaxial coupling to a complementary connector connected to a signal processing circuit (23).

10. The sensor of any preceding claim, further comprising an inner screen (4) surrounding the conducting wire, wherein the inner screen (4) is positioned between the conducting wire and the dielectric body.

11. The sensor of the preceding claim, wherein the inner screen (4) comprises or consists of a semiconductive material.

12. The sensor of any preceding claim, wherein the capacitive voltage sensing arrangement further comprises a signal processing circuit (23) which comprises the reference voltage source, and an output voltage measurement signal processing circuit.

13. The sensor of the preceding claim wherein the reference voltage source is configured to supply the reference voltage ***V_{ref}*** at a reference frequency ***f_{ref}*** greater than a line frequency of the voltage in the conducting wire, preferably at least 50% greater.

14. The sensor of any preceding claim, wherein a peak value of the reference voltage is at least 100 times smaller than a nominal line voltage in the conducting wire.

15. The sensor of any preceding claim, wherein the outer screen (5) comprises an opening (20) providing an access to the first output terminal (18a), the electrode and the dielectric body having respective portions extending through the opening of the outer screen, the outer conductor being mounted on top of the outer screen and around the opening of the outer screen.
